# EUROPÄISCHE PATENTSCHRIFT

(11) **EP 3 447 443 B1**
(45) Veröffentlichungstag und Bekanntmachung des Hinweises auf die Patenterteilung: **18.12.2019**
(21) Anmeldenummer: 17187589.1
(22) Anmeldetag: 23.08.2017
(51) Int. Cl.: G01C 9/06, E02F 9/26, B66C 23/90, B66F 17/00

(54) **MOBILE ARBEITSMASCHINE MIT EINEM NEIGUNGSSENSORSYSTEM**
MOBILE WORKING MACHINE WITH AN INCLINATION SENSOR SYSTEM
MACHINE DE TRAVAIL MOBILE AVEC UN SYSTÈME DE CAPTEUR D'INCLINAISON

(43) Veröffentlichungstag der Anmeldung: 27.02.2019
(73) Patentinhaber: MOBA Mobile Automation AG, 65555 Limburg (DE)
(72) Erfinder: RUPPEL, Jörg, 65555 Limburg (DE); BECHER, Dominik, 65555 Limburg (DE); ZILS, Boris, 65555 Limburg (DE)
(74) Vertreter: Pfitzner, Hannes

(56) Entgegenhaltungen:
- EP-A2- 1 528 357
- JP-A- 2001 097 697
- US-A1- 2011 067 250

## Beschreibung

Die vorliegende Erfindung bezieht sich auf eine mobile Arbeitsmaschine mit einem Neigungssensorsystem sowie auf ein entsprechendes Verfahren zur Neigungsmessung. Im Allgemeinen liegt die Erfindung auf dem Gebiet von mobilen Arbeitsmaschinen, und zwar einer Hubarbeitsbühne oder einem mobilen Lastkran. Bevorzugte Ausführungsbeispiele betreffen ein Sensorsystem zur Lagenivellierung eines auf dem Chassis der mobilen Arbeitsmaschine verstellbar bzw. verdrehbar angeordneten Aufbaus mit einem hydraulisch verstellbaren Maschinenteil, beispielsweise einem Teleskopausleger.

Die vorliegende Erfindung beschäftigt sich im Wesentlichen mit einem Problem, welches in der Praxis an einer Hubarbeitsbühne aufgetreten ist. Eine solche Hubarbeitsbühne ist aus der DE 100 32 423 A1 bekannt und beschreibt eine fahrbare Hubarbeitsbühne mit einem Fahrwerk und einem auf dem Fahrwerk angeordneten Auslegeraufbau, wobei der Auslegeraufbau an einem Drehturm beweglich befestigt ist und der Drehturm über ein Drehgetriebe drehbar an dem Fahrwerk angeordnet ist. Der Drehturm besteht aus einem Drehtisch und einen Nivellierturm, an dem der Auslegeraufbau beweglich befestigt ist, wobei der Nivellierturm und der Drehtisch über eine Drehachse verbunden sind und am Nivellierturm mindestens ein Neigungssensor zur Steuerung mindestens einer Hebe- und Senkvorrichtung angeordnet ist, so dass der Nivellierturm unabhängig von einer Neigung des Fahrwerks bzw. des Drehtisches mittels der Hebe- und Senkvorrichtung in ungefähr horizontaler Ausrichtung gehalten wird.

Hinsichtlich des Neigungssensors geht aus der DE 100 32 423 A1 über die verwendete Sensortechnologie nichts hervor. Es ist jedoch allgemein bekannt, dass Neigungssensoren in der beschriebenen Anwendung heutzutage sogenannte mikromechanische MEMS-Sensorelemente (Micro-Electro-Mechanical Systems) enthalten, da diese einige Vorteile aufweisen, wie beispielsweise eine hohe Genauigkeit sowie eine geringe Baugröße. Bei MEMS-Sensorelementen wird im Wesentlichen zwischen sogenannten "Surface- und Bulk-Micromachined-Sensoren" unterschieden. Neben einigen technischen Parametern und einem unterschiedlichen inneren Aufbau unterscheiden sich die beiden genannten Arten von MEMS-Sensorelementen auch deutlich im Preis. So sind die bekannten Bulk-Micromachined-MEMS-Sensoren mit einem Gas befüllt, wodurch diese kaum bzw. gar nicht in Resonanz versetzt werden können, da die Eigenfrequenz (Resonanzfrequenz) des Sensorelementes deutlich über dessen Grenzfrequenz liegt. Im Vergleich zu Surface-Micromachined-MEMS-Sensoren sind Bulk-Micromachined-MEMS-Sensoren jedoch ca. um das 3-fache teurer. Um Kosten einzusparen werden daher in Neigungssensoren oftmals MEMS-Sensoren mit Surface-Micromachined-Technologie eingesetzt.

Für eine Kran-Ausleger-Überwachung ist ferner aus der DE 42 43 978 C1 ein thermodynamischer Neigungs- und Beschleunigungssensor bekannt. Diese Sensorelemente weisen zwar einen geringen Preis auf, sind jedoch im Vergleich zu MEMS-Sensoren wesentlich ungenauer und empfindlicher gegenüber Änderungen der Umgebungstemperatur, so dass diese Art von Sensoren heutzutage üblicherweise nicht in der beschriebenen Anwendung eingesetzt wird. Hinsichtlich des Einsatzes im Bereich von mobilen Arbeitsmaschinen besteht daher Bedarf, ein Sensorsystem zur Lagenivellierung entsprechend zu verbessern.

Deshalb ist es Aufgabe der vorliegenden Erfindung, ein Konzept zur Neigungsmessung zu schaffen, das einen verbesserten Kompromiss aus Herstellkosten, Genauigkeit und Zuverlässigkeit bietet.

Die Aufgabe wird durch die unabhängigen Patentansprüche gelöst.

Die vorliegende Erfindung schafft ein Neigungssensorsystem mit einem MEMS-Neigungssensor, insbesondere einem sogenannten Surface-Micromachined-MEMS-Neigungssensor (Neigungssensor auf Basis von MEMS, hergestellt mit Oberflächentechnologien), einem weiteren Neigungssensor, speziell einem thermodynamischen Neigungssensor, sowie eine Fusionsvorrichtung. Der MEMS-Neigungssensor ist ausgebildet, um ausgehend von einer an dem Neigungssensor vorherrschenden Neigung ein erstes Neigungssignal auszugeben. Der weitere Neigungssensor umfasst einen thermodynamischen Neigungssensor und ist ausgebildet, um ausgehend von der an dem Neigungssensor vorherrschenden Neigung ein zweites Neigungssignal auszugeben. Die Fusionsvorrichtung ist ausgebildet, um eine korrigierte Neigung basierend auf dem ersten und zweiten Neigungssignal zu berechnen und als korrigiertes Neigungssignal auszugeben.

Die vorliegende Erfindung liegt die Erkenntnis zugrunde, dass thermodynamische Sensorelemente im Vergleich zu MEMS-Sensorelementen zwar ungenauer sind, aber vor allem auch unempfindlicher gegenüber den eingangs beschriebenen mechanischen Schwingungen bzw. Störungen, ursächlich ausgelöst durch ein problembehaftetes Getriebe an einer Hubarbeitsbühne. Hieraus ergab sich die Idee, zwei unterschiedliche Sensortechnologien miteinander in einem Neigungssensorsystem auf Basis zumindest eines MEMS-Neigungssensor zu kombinieren und somit mittels beispielsweise einem thermodynamischen Sensor zu detektieren, ob der MEMS-Neigungssensor aufgrund von mechanischen Schwingungen bzw. Störungen (wie oben beschrieben) ein fehlerhaftes Messsignal liefert oder nicht. Durch die Fusion beider Sensoren bzw. der Sensorsignale werden die Vorteile beider Technologien insbesondere für das sehr spezielle Problem der mechanischen Schwingungen, welche im niedrigen kHz-Bereich, insbesondere etwa im Bereich von 3 bis 4 kHz, liegen, gelöst. Durch die Verwendung zweier unterschiedlicher Sensortechnologien wird mit der vorliegenden Erfindung in vorteilhafter Weise ein vollständiges, redundantes und diversitäres Neigungssystem geschaffen.

Wie oben bereits angedeutet, ist der MEMS-Neigungssensor bevorzugt auf Basis von Oberflächen-MEMS-Technologien hergestellt. Bei einer derartigen Herstellung werden eine oder mehrere Schichten auf dem Substrat aufgewachsen bzw. aufgetragen, in welche die MEMS-Struktur eingebracht ist. Insofern umfasst ein derartig hergestellter MEMS-Neigungssensor ein Substrat, auf dessen Oberfläche die MEMS-Strukturen gebildet sind. Solche MEMS-Sensoren sind kostengünstig herzustellen und weisen eine hohe Genauigkeit auf. Entsprechend der Erfindung handelt es sich bei dem weiteren Neigungssensor des anderen Typs um einen sogenannten thermodynamischen Neigungssensor. Ein thermodynamischer Neigungssensor ist ebenfalls kostengünstig herzustellen und weist im Vergleich zu dem oben erläuterten MEMS-Neigungssensor (basierend auf Oberflächen-MEMS-Technologien) eine erhöhte Störunempfindlichkeit im Falle von Vibrationen auf.

Bei der Fusion gibt es unterschiedliche Ansätze, wie die zwei Neigungssignale miteinander kombiniert werden können. Entsprechend einem Ausführungsbeispiel wird beispielsweise das erste Neigungssignal verwendet, wenn keine Abweichung oder eine konstante Abweichung mit zwei Neigungssignalen vorliegt. Entsprechend einem anderen Ausführungsbeispiel kann bei einer Abweichung das zweite Neigungssignal verwendet werden. Entsprechend Ausführungsbeispielen kann die Fusionsvorrichtung ausgebildet sein, um das erste Neigungssignal mittels einer FFT (Fast Fourier Transformation) zu untersuchen und bei Erkennen einer Abweichung im Frequenzspektrum oder bei Überschreitung eines vorbestimmten Pegels eines oder mehrerer Frequenzanteile das zweite Neigungssignal als korrigiertes Neigungssignal ausgeben. Entsprechend weiteren Ausführungsbeispielen kann die Fusionsvorrichtung ausgebildet sein, um den zeitlichen Verlauf, insbesondere des ersten Neigungssignals hinsichtlich Unstetigkeiten zu untersuchen und bei Unstetigkeiten das zweite Neigungssignal als korrigiertes Neigungssignal ausgeben. Unstetigkeiten können sich entsprechend Ausführungsbeispielen auch durch eine sogenannte "Wertspitze" darstellen, die durch eine Signaländerung von mindestens 0,1%, 0,5%, 2%, 5% oder 10% gegenüber dem vorherigen Niveau innerhalb einer Zeitdauer von kleiner 100 ms, 500 ms, oder kleiner 1 Sekunde gekennzeichnet ist. Bei Vorliegen einer Wertspitze wird dann das zweite Neigungssignal als korrigiertes Neigungssignal genommen. Entsprechend einem weiteren Ausführungsbeispiel kann als Indiz für ein verfälschtes erstes Neigungssignal auch der zeitliche Verlauf hinsichtlich eines ansteigenden ersten Neigungssignals bis zu einer Plateaubildung an einem Maximalwert für das erste Neigungssignal untersucht werden, um dann bei Vorliegen eines derartigen charakteristischen Verlaufs dann das zweite Neigungssignal als korrigiertes Neigungssignal auszugeben.

Entsprechend einem weiteren Ausführungsbeispiel kann die Fusionsvorrichtung ausgebildet sein, um den zeitlichen Verlauf des ersten und/oder des zweiten Neigungssignals hinsichtlich eines Drifts zu beobachten, um einen aus dem Drift resultierenden Offsetfehler und/oder Verstärkungsfehler zu kompensieren oder um das Sensorsignal ohne Drift als korrigiertes Neigungssignal auszugeben. Entsprechend einem weiteren Ausführungsbeispiel kann das Sensorsystem einen oder mehrere Temperatursensoren zur Überwachung der Umgebungstemperatur des MEMS-Neigungssensors und/oder des weiteren Neigungssensors umfassen, wobei die Fusionsvorrichtung ausgebildet ist, um das korrigierte Neigungssignal unter Berücksichtigung von einem oder mehreren Temperaturwerten der einen oder mehreren Temperatursensoren zu bestimmen und/oder das erste, das zweite und/oder das korrigierte Neigungssignal in Abhängigkeit von den einen oder mehreren Temperaturwerten zu korrigieren.

Entsprechend der Erfindung wird eine Arbeitsmaschine, wie eine Hubarbeitsbühne oder ein Kran geschaffen, der einen derartigen Neigungssensor umfasst. Der Neigungssensor kann beispielsweise an dem Oberwagen, Ausleger, Teleskopausleger oder der Arbeitsbühne angeordnet sein.

Die Erfindung schafft ein entsprechendes Verfahren nach Anspruch 13, welches entsprechend der Erfindung auch unter Zuhilfenahme eines Computers ausgeführt wird.

Weiterbildungen sind in den Unteransprüchen definiert. Ausführungsbeispiele der vorliegenden Erfindung werden anhand der beiliegenden Zeichnungen erläutert. Es zeigen:
- Fig. 1: ein schematisches Blockschaltbild eines Neigungssensors gemäß einem Ausführungsbeispiel;
- Fig. 2a-2d: eine schematische Darstellung einer Hubarbeitsbühne bei unterschiedlichen Bewegungen, die negative Auswirkungen auf Neigungssignale haben können;
- Fig. 3 und 4: weitere schematische Darstellungen von Arbeitsmaschinen, bei denen Verfälschungen des Neigungssignals infolge von Bewegungen auftreten können; und
- Fig. 5: ein schematisches Diagramm der Sensorsignale zugehörig zu dem Neigungssensorsystem aus Fig. 1.

Bevor nachfolgend Ausführungsbeispiele der vorliegenden Erfindung anhand der Figuren im Detail erläutert werden, sei darauf hingewiesen, das gleiche Elemente und Strukturen mit gleichen Bezugszeichen versehen sind, so dass die Beschreibung derer aufeinander anwendbar bzw. austauschbar ist.

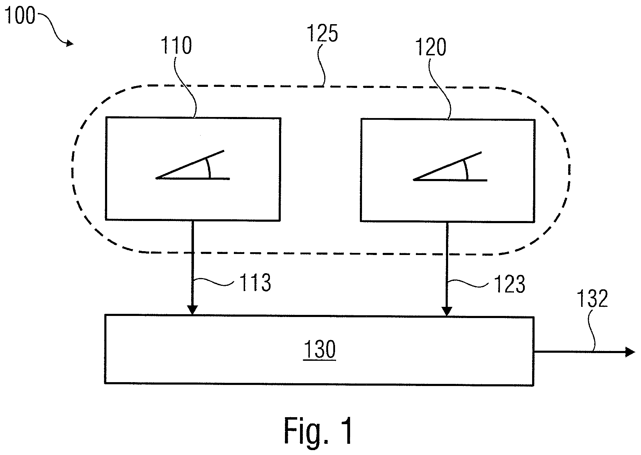

Fig. 1 zeigt ein für die Neigungsmessung bzw. Messung zur Lagenivellierung verwendetes Sensorsystem 100. Dieses umfasst einen MEMS-Sensor 110, einen thermodynamischen Sensor 120 bzw. allgemein einen Neigungssensor eines anderen Typs. Ferner umfasst das Sensorsystem 110 zusätzlich auch noch eine Berechnungseinheit 130. Die drei Einheiten 110, 120 und 130 bzw. zumindest die zwei Sensoren 110 und 120 sind in ihrer Bewegung miteinander gekoppelt, z. B. über ein gemeinsames Gehäuse 125, so dass beide Sensoren 110 und 120 in Abhängigkeit von der Bewegung des gemeinsamen Gehäuses 125 bzw. in Abhängigkeit von der gemeinsamen Bewegung dieselbe Neigung erfahren. Insofern sollten beide Neigungssensoren 110 und 120 unabhängig voneinander ihre Neigung bzw. Lage in Bezug auf die Schwerkraft ermitteln und vergleichbare Neigungssignale 113 und 123 ausgeben.

MEMS-Neigungssensoren, hier der Neigungssensor 110, weisen häufig den Nachteil auf, dass äußere Einflüsse, wie beispielsweise Schwingungen oder Störungen, auf den Sensor einwirken und dessen Arbeitsverhalten beeinträchtigen sowie das Messergebnis stark verfälschen können. Wie in der Praxis mit einem Schwingungsanalysator festgestellt, so werden an einer wie oben beschriebenen Hubarbeitsbühne durch das Drehgetriebe mechanische Schwingungen bzw. Störungen erzeugt, und zwar immer dann, wenn der Drehturm gegenüber dem Fahrwerk verdreht wird. Wie Messungen ergeben haben, liegen diese mechanischen Schwingungen bzw. Störungen im unteren kHz-Bereich, d.h. etwa im Bereich von 3 bis 4 kHz. Über das Gehäuse 125 des Neigungssensors, welcher fest mit dem Dreh- bzw. Nivellierturm verbunden ist, wirken diese mechanischen Schwingungen bzw. Störungen auf die MEMS-Sensorelemente 110 ein und versetzen diese in Eigenschwingung (Resonanz), so dass es zu Messwertabweichungen kommt, ohne dass eine tatsächliche Neigungsänderung gegeben ist. Beispielsweise steigt während der Schwingungseinwirkung das ausgegebene Messsignal des MEMS-Sensors langsam bis zur oberen Signalgrenze an und verharrt dort solange, bis das Verdrehen des Drehturms beendet ist und die Schwingungseinwirkung demzufolge nachlässt.

Das beobachtete und geschilderte Problem, ausgelöst durch das Drehgetriebe, ist dem sogenannten "Slip-Stick-Effekt" zuzuordnen, d. h. das Entstehen von Schwingungen beim Reiben bzw. Ruckgleiten von gegeneinander bewegten Festkörpern. Dieser Effekt ist ferner auch bei Hydraulikzylindern zu beobachten, wie sie auch bei Hubarbeitsbühnen oder mobilen Ladekränen verwendet werden. Bei Alterung des Zylinders und der Dichtungen entsteht beim Verfahren des Zylinders (Ein- bzw. Ausfahren der Schub- bzw. Kolbenstange) ein Ruckeln, wodurch die Mechanik zu breitbandigen Schwingungen angeregt wird. Diese Schwingungen übertragen sich dann auf alle an der Mechanik angeordneten Komponenten, wie beispielsweise ein Sensorsystem zur Lagenivellierung, welches am Drehturm oder am Teleskoparm einer Hubarbeitsbühne oder eines mobilen Ladekrans angeordnet ist. Somit entstehen die oben beschriebenen mechanischen Schwingungen bzw. Störungen auch beispielsweise beim Anheben oder Absenken des Arbeitskorbs einer Hubarbeitsbühne, oder aber auch beim Ein- und Ausfahren des Teleskoparms eines mobilen Ladekrans.

Ausgehend von diesen Nachteilen des Sensors 110 wird nun der thermodynamische Sensor 120 ergänzt, der ausgehend von einem anderen Sensorprinzip nicht infolge des Slip-Stick-Effekts gestört wird. Hierfür eignen sich, wie eingangs bereits erwähnt, thermodynamische Neigungs- bzw. Beschleunigungssensoren.

Nachdem nun zwei Sensorsignale 113 und 123 vorliegen, können diese mittels der Berechnungsvorrichtung 130 dahin gehend ausgewertet werden, ob das aus Sicht der Genauigkeit zu präferierende Sensorsignal 113 fehlerbehaftet ist oder nicht. Hierzu gibt es wie folgt mehrere Möglichkeiten, wobei es die Erfindung offen lässt, nur eine dieser Möglichkeiten zu verwenden oder mehrere Möglichkeiten miteinander zu kombinieren.

Eine dieser Möglichkeiten besteht darin, das Sensorsignal 113 mittels einer FFT (Fast Fourier Transformation) zu überprüfen. Ist aus dem Frequenzspektrum zu erkennen, dass die Abweichung aus einer externen Störung und nicht aus einer Winkeländerung resultiert, so kann die Berechnungseinheit 130 als korrigiertes Sensorsignal 132 statt dem Sensorsignal 113 (genaueres Signal) das Sensorsignal 123 ausgeben. Sobald das Ausgangssignal (Sensorsignal 113) des MEMS-Sensors 110 übersteuert ist, treten Signalverzerrungen auf. In einem stark tiefpassgefilterten Sensorsignal 113 bewirken diese Signalverzerrungen einen Neigungsfehler (Offset). Allerdings lässt sich aus diesem Signal die eigentliche Ursache der Neigungsänderung nicht mehr ermitteln, d. h. es lässt sich nicht mehr ermitteln, ob es sich um eine gewöhnliche Neigungsänderung des Sensorsystems 100 oder um eine Signalverzerrung aufgrund von äußeren Einflüssen, wie beispielsweise Schwingungen oder Störungen, die auf das Sensorsystem 100 einwirken, handelt. Daher sollte das Sensorsignal 113 möglichst ungefiltert alle Frequenzanteile des Übertragungsbereichs des MEMS-Sensors 110 enthalten. Eine solche Überprüfung mittels einer FFT kann entweder per Software oder aber per Hardware durchgeführt werden, d. h. vorzugsweise durch einen Mikrocontroller in der Berechnungseinheit 130. Bei entsprechend hoher Abtastrate lässt sich eine Übersteuerung des MEMS-Sensors 110 per Software mit jedem Einzelwert erkennen und so beurteilen, ob das Sensorsignal 113 fehlerbehaftet ist oder nicht. Steht nur eine geringe Abtastrate durch die Hardware (Mikrocontroller nebst Peripherie) zur Verfügung, kann das ungefilterte Sensorsignal 113 mit einem Komparator auf die Überschreitung eines vorbestimmten Pegels eines oder mehrerer Frequenzanteile überwacht werden (sogenannten Peak Detektor). Das Ausgangssignal des Peak-Detektors kann beispielsweise in der Berechnungseinheit 130 einen Interrupt auslösen, der wiederum zur Beurteilung, ob das Sensorsignal 113 fehlerbehaftet ist oder nicht, verwendet wird.

Denkbar wäre auch ein Vergleich der Sensorsignale 113 und 123. Wenn beispielsweise das Sensorsignal 113 von einem gleichen oder vergleichbaren Niveau in Bezug auf das Sensorsignal 123 abweicht bzw. nach kurzer Zeit abweicht, so kann vermutet werden, dass die Abweichung aus einer externen Störung und nicht aus einer Winkeländerung resultiert, so dass dann durch die Berechnungseinheit 130 als korrigiertes Sensorsignal 132 statt dem Sensorsignal 113 (genaueres Signal) das Sensorsignal 123 ausgegeben wird. Hierbei wäre es auch möglich, dass die Berechnungseinheit 130 durch einen Vergleich der Sensorsignale 113 und 123 eine Abweichung von beispielsweise +/- 0,1 Grad oder +/- 0,2 Grad Neigung ermittelt, d. h. das eigentlich zu präferierende Sensorsignal 113 des MEMS-Sensors 110 weicht beispielsweise gegenüber dem Sensorsignal 123 um eine Neigung von +/- 0,1 Grad oder +/- 0,2 Grad ab. Dies könnte die Berechnungseinheit 130 bereits dazu veranlassen, das zweite Sensorsignal 123 als korrigiertes Sensorsignal 132 auszugeben bzw. weiterzuleiten.

Entsprechend Ausführungsbeispielen wird eine Störung beispielsweise dann detektiert, wenn sich Unstetigkeiten im Verlauf des Sensorsignals 113 ergeben. Derartige Unstetigkeiten können sich darstellen durch eine temporäre Abweichung (mindestens 0,1%, 0,5%, 2%, 5% oder 10% innerhalb von einem Zeitfenster kleiner 100 ms, 500 ms oder kleiner 1 Sekunde) oder auch durch einen konstanten Anstieg bis zu einem Plateau am Sensormaximum. Auch im Falle eines so detektierten Fehlverhaltens des Sensors 110 kann dann die Berechnungseinheit 130 das Sensorsignal 123 als korrigiertes Sensorsignal 132 weiterleiten.

Bei allen zuvor beschriebenen Auswertungen ist jedoch zu beachten, dass die Messergebnisse des MEMS-Sensors 110 und insbesondere des thermodynamischen Sensors 120 von der Temperatur abhängig sind, sodass eine Entscheidung, welches der beiden Sensorsignale 113 und 123 von der Berechnungseinheit 130 als korrigiertes Sensorsignal 132 ausgegeben bzw. weitergeleitet wird, nicht ohne weiteres erfolgen kann. Auch ist hier eine Sensordrift (Offsetdrift) des insbesondere thermodynamischen Sensors 120 bei einer Entscheidung, welches der beiden Sensorsignale 113 und 123 als korrigiertes Sensorsignal 132 ausgegeben bzw. weitergeleitet werden kann, von der Berechnungseinheit 130 zu berücksichtigen. Die Berechnungseinheit 130 kann demnach entsprechend ausgebildet sein, um den zeitlichen Verlauf des ersten und/oder des zweiten Neigungssignals 113, 123 hinsichtlich eines Drifts zu beobachten, um einen aus dem Drift resultierenden Offsetfehler und/oder Verstärkungsfehler zu kompensieren oder um das Sensorsignal ohne Drift als korrigiertes Neigungssignal 132 auszugeben.

Bei der Auswertung der beiden Sensorsignale 113 und 123 durch die Berechnungseinheit 130 ist es demnach von Vorteil, vor einer Entscheidung, welches der beiden Sensorsignale 113 und 123 als korrigiertes Sensorsignal 132 ausgegeben bzw. weitergeleitet werden kann, eine Temperaturveränderung im Bereich der Sensoren 110 und 120 über einen entsprechenden Zeitraum, beispielsweise im Bereich von wenigen Sekunden bis hin zu einigen Minuten, zu beobachten. Hierzu kann vorzugsweise in der Nähe der Sensoren 110 und/oder 120 ein oder mehrere Temperatursensoren angeordnet sein. Die gemessenen Temperaturwerte werden bei der Auswertung der beiden Sensorsignale 113 und 123 berücksichtigt, d. h. fließen in die Auswertung mit ein. Die Berechnungseinheit 130 kann demnach entsprechend ausgebildet sein, um das korrigierte Neigungssignal 132 unter Berücksichtigung von einem oder mehreren Temperaturwerten der einen oder mehreren Temperatursensoren zu bestimmen und/oder das erste, das zweite und/oder das korrigierte Neigungssignal 132 in Abhängigkeit von den einen oder mehreren Temperaturwerten zu korrigieren. Hat sich die Temperatur insbesondere im Bereich des thermodynamischen Sensors 120 kaum oder gar nicht verändert, beispielsweise um weniger als 0,5 Grad Celsius, und das Sensorsignal 113 des MEMS-Sensors 110 scheint fehlerbehaftet zu sein oder es scheint ein Fehlverhalten des Sensors 110 vorzuliegen, so kann die Berechnungseinheit 130 dann das Sensorsignal 123 als korrigiertes Sensorsignal 132 ausgegeben bzw. weiterleiten.

Hat sich dagegen die Temperatur insbesondere im Bereich des thermodynamischen Sensors 120 erhöht oder verringert, beispielsweise um mindestens 1 Grad Celsius, und das Sensorsignal 113 scheint fehlerbehaftet zu sein oder es scheint ein Fehlverhalten des Sensors 110 vorzuliegen, so kann die Berechnungseinheit 130 dann das Sensorsignal 123 nicht ohne weiteres als korrigiertes Sensorsignal 132 ausgegeben bzw. weiterleiten. Die Berechnungseinheit 130 muss nun weitere Maßnahmen durchführen, wie beispielsweise eine Kompensation des Sensorsignals 123 anhand einer im Speicher hinterlegten Temperaturkurve. Diese Temperaturkurve kann beispielsweise bei einer Kalibrierung des Sensorsystems 100 ermittelt werden oder wird durch den Sensorelemente-Hersteller des Sensors 120 bereitgestellt. Nach entsprechender Kompensation des Sensorsignals 123 kann die Berechnungseinheit 130 dann das Sensorsignal 123 als korrigiertes Sensorsignal 132 ausgegeben bzw. weiterleiten.

Es versteht sich, dass die beiden Sensorsignale 113 und 123 unabhängig davon, welches der beiden Sensorsignale 113 oder 123 gerade als korrigiertes Sensorsignal 132 ausgegeben bzw. weitergeleitet wird, kontinuierlich von der Berechnungseinheit 130 überprüft und ausgewertet werden, um die Verfügbarkeit des Sensorsystems 100 zu erhöhen. Ist von der Berechnungseinheit 130 keines der beiden Sensorsignale 113 und 123 als zuverlässig einzustufen, da beispielsweise das Sensorsignal 113 fehlerbehaftet zu sein scheint oder ein Fehlverhalten des Sensors 110 vorliegt und eine zu hohe Umgebungstemperatur sowie eine nicht zu kompensierende Offsetdrift des thermodynamischen Sensors 120 vorliegt, dann sollte anstelle eines korrigierten Sensorsignals 132 eine Fehlermeldung ausgegeben werden, um Schäden von Mensch und Maschine zu vermeiden.

Die kontinuierliche und gegenseitige Überprüfung und Auswertung der beiden Sensorsignale 113 und 123 durch die Berechnungseinheit 130 kann in vorteilhafter Weise auch dazu verwendet werden, um bei einer Temperaturänderung insbesondere im Bereich des thermodynamischen Sensors 120, beispielsweise um mindestens 1 Grad Celsius, eine Kompensation des Sensorsignals 123 durchzuführen, sofern das Sensorsignal 113 des MEMS-Sensors 110 nicht fehlerbehaftet zu sein scheint oder ein Fehlverhalten des Sensors 110 nicht vorliegt. Das aus Sicht der Genauigkeit zu präferierende Sensorsignal 113 kann dann beispielsweise zusätzlich zu der bereits genannten Kompensation mittels einer im Speicher hinterlegten Temperaturkurve verwendet werden, oder aber auch - sofern beispielsweise keine Temperaturkurve vorhanden ist - zur alleinigen Kompensation einer Temperaturdrift des thermodynamischen Sensors, d. h. zur Kompensation einer Drift des Sensorsignals 123 aufgrund von Temperaturänderungen, hinzugezogen werden. Wie bereits oben beschrieben, so kann die Berechnungseinheit 130 demnach entsprechend ausgebildet sein, um den zeitlichen Verlauf des ersten und/oder des zweiten Neigungssignals 113, 123 hinsichtlich eines Drifts zu beobachten, um einen aus dem Drift resultierenden Offsetfehler und/oder Verstärkungsfehler zu kompensieren.

Entsprechend weiteren Ausführungsbeispielen können auch die beiden Sensorsignale kombiniert werden, wobei je nach Abweichung z. B. eine Gewichtung der zwei Sensorsignale untereinander verschoben wird.

Nachfolgend werden typische Anwendungen für das Sensorsystem 100 erläutert.

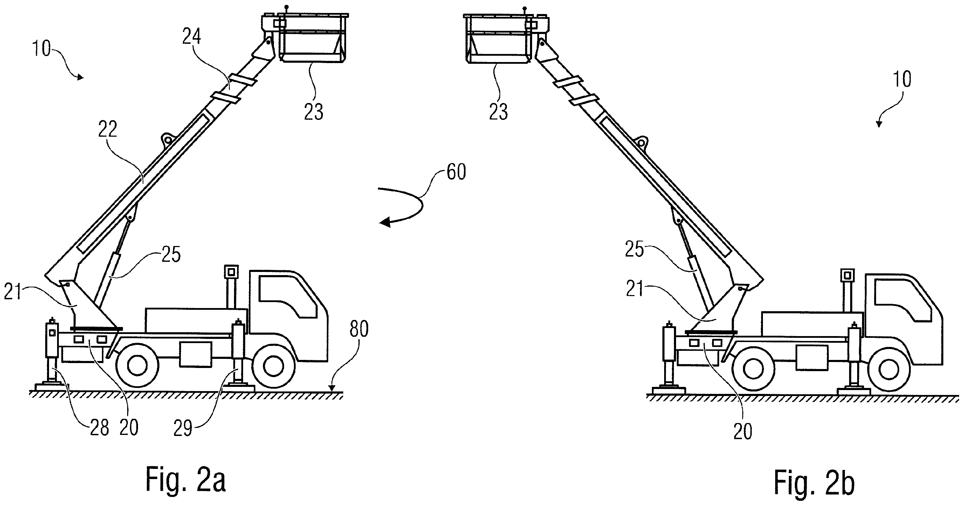

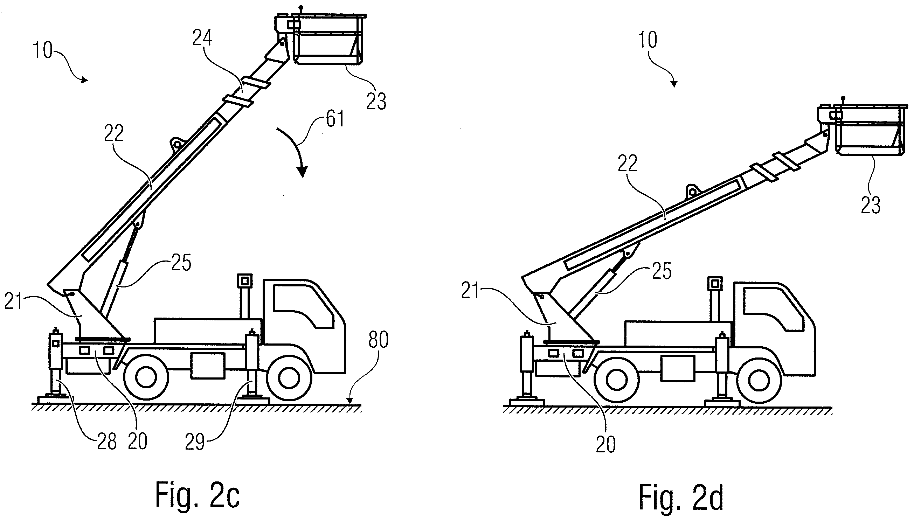

In den Fig. 2a, 2b, 2c und 2d ist jeweils eine Hubarbeitsbühne 10 mit einem Chassis 20 und einem darauf drehbar angeordneten Oberwagen 21, an dem ein Teleskopausleger 22 beweglich befestigt ist, dargestellt. Mittels einer an dem Oberwagen 21 und an dem Teleskopausleger 22 angeordneten Hubzylinders 25 kann der Teleskopausleger 22 nach oben oder nach unten bewegt werden. Am Teleskopausleger 22 befinden sich weitere ein- und ausfahrbare Stufen 24, bei den in den Figuren 1 und 2 gezeigten Beispielen sind zwei Stufen vorgesehen. An der letzten Stufe des Teleskopauslegers 22 ist ein Arbeitskorb 23 derart beweglich befestigt, dass dieser stets in der Horizontalen gehalten wird. Durch seitlich am Chassis 20 der Hubarbeitsbühne 10 angeordnete Stützen 28 und 29 kann die Hubarbeitsbühne 10 sicher und standfest auf einem Untergrund 80 abgestellt werden.

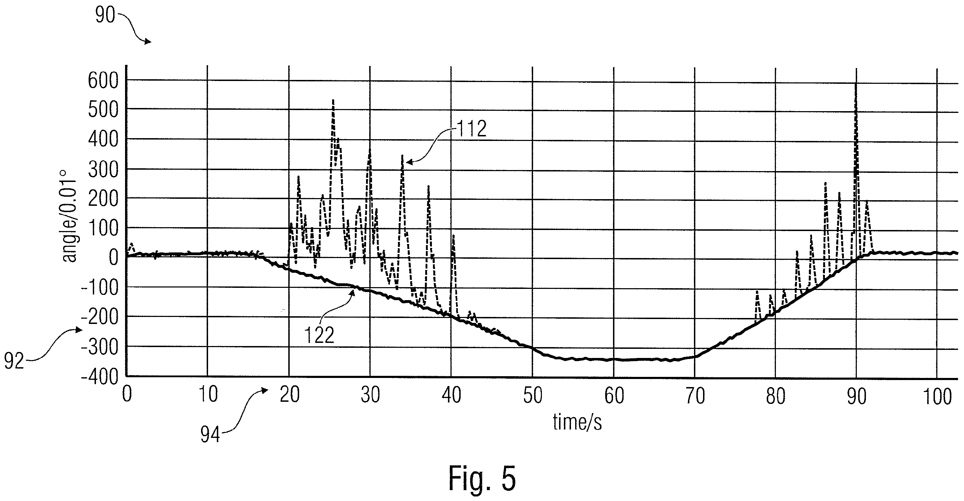

In Fig. 2b ist der Oberwagen 21 im Vergleich zu Fig. 2a um 180° verdreht dargestellt. In der Praxis wurde gerade bei einer solchen Drehbewegung 60 des Oberwagens 21 festgestellt, dass durch das Drehgetriebe mechanische Schwingungen bzw. Störungen im niedrigen bzw. unteren kHz-Bereich, d. h. ungefähr im Bereich von 3 bis 4 kHz, erzeugt werden, die auf ein im Oberwagen 21 angeordnetes Sensorsystem einwirken und dieses derart beeinflussen, dass es zu Messwertabweichungen kommt, ohne dass eine tatsächliche Neigungsänderung der Hubarbeitsbühne 10 gegeben ist. Solche auf ein Sensorsystem einwirkende Schwingungen oder Störungen sind in Fig. 5 dargestellt und werden weiter unten ausführlicher beschrieben.

Bei der hier dargestellten Hubarbeitsbühne 10 kann das Bezug nehmend auf Fig. 1 erläuterte Sensorsystem 100 zur Lagenivellierung der Hubarbeitsbühne 10 beispielsweise an dem Teleskopausleger 22 oder dem Arbeitskorb 23 installiert sein, um die Neigung des Teleskopauslegers 22 oder des Arbeitskorbes 23 zu ermitteln. Auch wäre eine Befestigung an dem Oberwagen 21 oder dem Chassis 20 denkbar, um eine Neigung des Fahrzeugs gegenüber der Ebene 80 zu ermitteln. Durch die Verwendung des verbesserten Sensorsystems 100 gegenüber den sonst typisch verwendeten Neigungssensoren kann sichergestellt werden, dass eine hochpräzise Messung mit geringer Störanfälligkeit erfolgt. Das Messsignal 132 (vgl. Fig. 1) würde dann durch die Berechnungseinheit 130 ausgehend von den Sensorsignalen 113 und 123 der Sensoren 110 und 120 ausgegeben. Das Sensorsignal 132 dient dann beispielsweise als Nivellierungssignal für eine beispielsweise übergeordnete Maschinensteuerung (nicht dargestellt). Wie bereits eingangs erwähnt, ist das Sensorsystem 100 im Vergleich zu alternativen Neigungssensoren in seinen Herstellungs- und Anschaffungskosten reduziert.

Mechanische Schwingungen, wie sie bei einer Drehbewegung 60 des Oberwagens 21 festgestellt wurden, sind auch bei einer Bewegung 61 des Teleskopauslegers 22 möglich, wenn dieser nach oben oder nach unten bewegt wird, wie in den Fig. 2c und 2d dargestellt. Dabei entstehen vergleichbare mechanische Schwingungen bzw. Störungen, die auf alle an der Mechanik angeordneten Komponenten, wie beispielsweise ein Sensorsystem zur Lagenivellierung, welches am Oberwagen 21 angeordnet ist, übertragen werden. Solche mechanischen Schwingungen bzw. Störungen entstehen beispielsweise durch Ruckeln des Zylinders beim Verfahren (Ein- bzw. Ausfahren der Schub- bzw. Kolbenstange) bedingt durch Alterung des Zylinders und der Dichtungen.

Auch bei der Bewegung, wie sie hier Bezug nehmend auf die Figuren 2c und 2d erläutert sind, zeichnet sich das Sensorsystem 100 durch erhöhte Zuverlässigkeit und Verfügbarkeit aus.

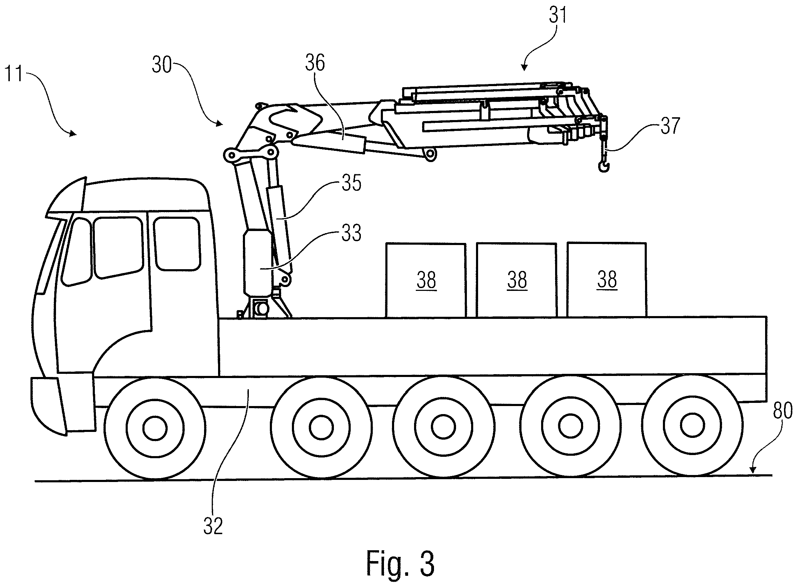

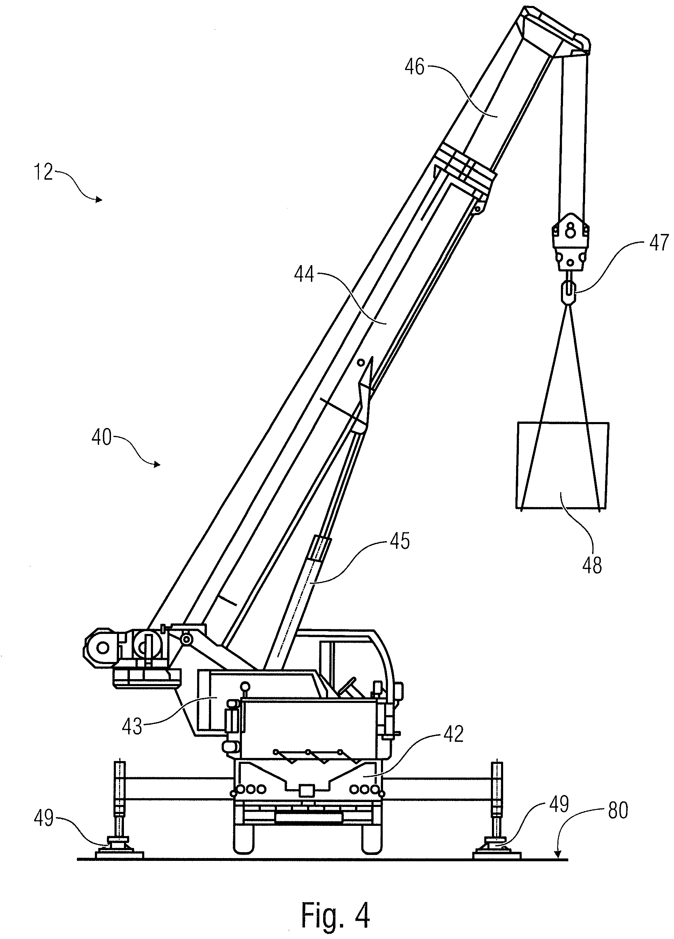

Nachfolgend werden Bezug nehmend auf die Fig. 3 und 4 weitere Anwendungsbeispiele zum Einsatz des Sensorsystems 100 ausgeführt. In den Fig. 3 und 4 sind weitere Beispiele von Maschinen dargestellt, bei denen Schwingungen durch problembehaftete Drehgetriebe und/oder gealterte und somit nicht mehr ruckelfrei laufende Hydraulikzylinder hervorgerufen werden könnten. Fig. 3 zeigt ein Fahrzeug 11 mit einem auf dessen Chassis 32 angeordneten Ladekran 30, der aus einem drehbaren Oberwagen 33 sowie mehreren Teleskopauslegerstufen 31 besteht. An der letzten Stufe des Teleskopauslegers 31 ist ein Kranhaken 37 befestigt, womit Lasten 38 auf- und abgeladen werden können. Der Ladekran 30 ist durch Hydraulikzylinder 35 und 36 bewegbar, d. h. der Teleskopausleger 31 kann durch Ein- und Ausfahren der Hydraulikzylinder 35 und 36 beispielsweise nach unten oder nach oben bewegt werden.

Fig. 4 zeigt einen Mobilkran 12 mit einem auf einem Chassis 42 des Mobilkrans 12 drehbar angeordneten Oberwagen 43, an dem ein Kranarm 40 beweglich angeordnet ist. Der Kranarm 40 besteht aus im Wesentlichen einem Teleskopausleger 44, welcher mit einem Hubzylinder 45 beispielsweise nach oben oder nach unten bewegt werden kann. Weiterhin besteht der Teleskopausleger 44 aus mehreren Stufen 46, wobei an der letzten Stufe des Teleskopauslegers 44 ein Kranhaken 47 zum Heben von Lasten 48 angeordnet ist.

Sowohl in dem in Fig. 3 dargestellten Fahrzeug 11 als auch in dem im Fig. 4 dargestellten Mobilkran 12 kann das Sensorsystem 100 verwendet werden, um eine genaue und zuverlässige Neigungsmessung an den einzelnen Komponenten zu ermöglichen. Hierbei ist das Befestigen wiederum sowohl an den beweglichen Elementen, wie z. B. der Teleskopauslegerstufe 31 bzw. 44 beim Kranarm 40. Natürlich kann auch hier eine Anordnung, je nach Einsatzzweck, des Sensorsystems an dem Chassis 32 bzw. 42 vorgesehen sein.

Nachdem nun ausführlich die möglichen Einsatzzwecke für das Sensorsystem 100 erläutert wurden, werden Bezug nehmend auf Fig. 5 die Sensorsignale der zwei Neigungssensoren 113 und 123 hinsichtlich ihres Verhaltens bei Neigung und/oder Störung erläutert.

Fig. 5 zeigt in einem Diagramm 90 Messwerte, die während einer Drehbewegung 60 des Oberwagens 21 einer Hubarbeitsbühne 10 um 90 Grad, wie prinzipiell in Fig. 2a, 2b dargestellt, von einem Sensorsystem zur Lagenivellierung ausgegeben wurden. Die Hubarbeitsbühne 10 war während der Drehbewegung und der Messung um ca. 3,5 Grad seitlich geneigt, da sich unter diesen Umständen die bereits oben beschriebenen mechanischen Schwingungen bzw. Störungen, ausgelöst durch das Drehgetriebe, recht gut und auch reproduzierbar erzeugen ließen. Für die Messung wurde bewusst ein derart kombiniertes Sensorsystem 100 gewählt, um die Messergebnisse beider Sensortechnologien in dieser Anwendung miteinander vergleichen zu können.

Diese Messergebnisse sind in Fig. 5 in dem Diagramm 90 anhand zweier Messwertkurven 112 und 122 dargestellt. Die Messwertkurve 112 zeigt dabei die von einem MEMS-Sensor 110 ausgegebenen Messwerte 113, wohingegen die Messwertkurve 122 die von einem thermodynamischen Sensor 120 ausgegebenen Messwerte 123 zeigt. Auf der Y-Achse 92 ist der Neigungswinkel und auf der X-Achse 94 die Zeit aufgetragen. Nach ca. 15 Sek. beginnt eine erste Drehbewegung des Oberwagens 21 gegenüber dem Chassis 20 bis zu einem Verdrehwinkel von ca. 90 Grad. Diese Drehbewegung ist nach ca. 40 Sek. beendet und der Oberwagen 21 bleibt für ca. 15 Sek. in dieser seitlichen Position, bevor er wieder in die Ausgangsposition (Drehung um 90 Grad) zurück bewegt wird. Es ist deutlich zu erkennen, dass die Messwertkurve 112 des MEMS-Sensors 110 starke Schwankungen aufweist, d. h. die oben beschriebenen mechanischen Schwingungen bzw. Störungen wirken direkt auf den MEMS-Sensor 110 ein und spiegeln sich in dem ausgegebenen Messwertsignal 113 (Messwertkurve 112) wieder. Bei dem thermodynamischen Sensor 120 hingegen sind keinerlei Schwankungen in der Messwertkurve 122 zu erkennen. Hierbei wirken die oben beschriebenen mechanischen Schwingungen bzw.

Störungen zwar auf den Sensor 120 ein, jedoch haben diese keine Auswirkungen auf das Messverhalten des Sensors, d. h. dieser wird überhaupt nicht beeinflusst.

Auch wenn in obigen Ausführungsbeispielen immer davon ausgegangen wurde, dass es sich bei den Sensoren 110 und 120 einmal um einen MEMS-Sensor, insbesondere einem MEMS-Sensor auf Basis von Oberflächen-MEMS-Technologien und um einen thermodynamischen Sensor handelt, sei an dieser Stelle angemerkt, dass auch andere Kombinationen von MEMS-Sensoren und einem weiteren Sensor möglich sind. Als zusätzlicher MEMS-Sensor kommt beispielsweise der MEMS-Sensor in der oben beschriebenen Bulk-Micromachined-Technologie in Betracht. Diese Sensoren sind - wie bereits beschrieben - mit einem Gas befüllt, wodurch diese kaum bzw. gar nicht in Resonanz versetzt werden können, da die Eigenfrequenz (Resonanzfrequenz) des Sensorelementes deutlich über dessen Grenzfrequenz liegt. Es sei hierbei angemerkt, dass eine Kombination dieser beiden MEMS-Technologien auch als Ausführungsvariante gesehen werden kann. Anstelle eines thermodynamischen Sensors könnte alternativ ein Flüssigkeitssensor eingesetzt werden. Bei einem Flüssigkeitssensor wird eine Neigung durch Reflexion oder Brechung eines Lichtstrahls durch den Flüssigkeitspegel oder durch eine Widerstandsmessung bzw. Kapazitätsmessung in Abhängigkeit von der Lage der Flüssigkeit erfasst.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Die Erfindung umfasst das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Mobile Arbeitsmaschine (10, 11, 12) mit einem Neigungssensorsystem (100), mit folgenden Merkmalen:
einen MEMS-Neigungssensor (110), der ausgebildet ist, um ausgehend von einer an dem Neigungssensor vorherrschenden Neigung ein erstes Neigungssignal (113) auszugeben;
einen weiteren Neigungssensor (120) eines anderen Typs, der ausgebildet ist, um ausgehend von der an dem weiteren Neigungssensor vorherrschenden Neigung ein zweites Neigungssignal (123) auszugeben, wobei der weitere Neigungssensor (120) einen thermodynamischen Neigungssensor umfasst; und
eine Fusionsvorrichtung (130), die ausgebildet ist, um eine korrigierte Neigung basierend auf dem ersten (113) und zweiten Neigungssignal (123) zu bestimmen oder zu berechnen und als korrigiertes Neigungssignal (132) auszugeben;
wobei die Arbeitsmaschine eine Hubarbeitsbühne oder ein Kran ist und wobei zumindest der MEMS-Neigungssensor (110) und der weitere Neigungssensor (120) in einem gemeinsamen Gehäuse (125) des Neigungssensorsystems (100) angeordnet sind.

2. Arbeitsmaschine gemäß Anspruch 1, wobei der MEMS-Neigungssensor (110) basierend auf Oberflächen-MEMS-Technologien hergestellt ist.

3. Arbeitsmaschine gemäß Anspruch 2, wobei der MEMS-Neigungssensor (110) ein oder mehrere auf ein Substrat aufgewachsene Schichten umfasst, in welchen die MEMS-Struktur eingebracht ist und/oder wobei der MEMS-Neigungssensor (110) ein Substrat umfasst, auf dessen Oberfläche die MEMS-Strukturen gebildet sind.

4. Arbeitsmaschine gemäß einem der vorhergehenden Ansprüche, wobei die Fusionsvorrichtung (130) ausgebildet ist, um das erste (113) und zweite Neigungssignal (123) zu vergleichen und ohne Abweichungen das erste Neigungssignal (113) als korrigiertes Neigungssignal (132) auszugeben.

5. Arbeitsmaschine gemäß einem der vorhergehenden Ansprüche, wobei die Fusionsvorrichtung (130) ausgebildet ist, um das erste (113) und zweite Neigungssignal (123) zu vergleichen und bei Abweichungen das zweite Neigungssignal (123) als korrigiertes Neigungssignal (132) auszugeben.

6. Arbeitsmaschine gemäß einem der vorhergehenden Ansprüche, wobei die Fusionsvorrichtung (130) ausgebildet ist, um das erste Neigungssignal (113) mittels einer FFT zu untersuchen und bei Erkennen einer Abweichung im Frequenzspektrum oder bei Überschreitung eines vorbestimmten Pegels eines oder mehrerer Frequenzanteile das zweite Neigungssignal (123) als korrigiertes Neigungssignal (132) ausgeben.

7. Arbeitsmaschine gemäß einem der vorhergehenden Ansprüche, wobei die Fusionsvorrichtung (130) ausgebildet ist, einen zeitlichen Verlauf des ersten Neigungssignals (113) hinsichtlich Unstetigkeiten zu untersuchen und bei Unstetigkeiten das zweite Neigungssignal (123) als korrigiertes Neigungssignal (132) auszugeben.

8. Arbeitsmaschine gemäß einem der vorhergehenden Ansprüche, wobei die Fusionsvorrichtung (130) ausgebildet ist, um in einem zeitlichen Verlauf des ersten Neigungssignals (113) Wertespitzen zu detektieren, die durch eine Signaländerung von mindestens 0,1%, 0,5%, 2%, 5% oder 10% gegenüber dem vorherigen Niveau innerhalb einer Zeitdauer von kleiner 100 ms, 500 ms, oder kleiner 1 Sekunde gekennzeichnet sind, und um bei Vorliegen von Wertespitzen das zweite Neigungssignal (123) als korrigiertes Neigungssignal (132) auszugeben.

9. Arbeitsmaschine gemäß einem der vorhergehenden Ansprüche, wobei die Fusionsvorrichtung (130) ausgebildet ist, um den zeitlichen Verlauf des ersten Neigungssignals (113) hinsichtlich eines charakteristischen Verlaufs zu untersuchen, der durch ein ansteigendes erstes Neigungssignal (113) mit einer anschließenden Plateaubildung an einem Maximalwert für das erste Sensorsignal gekennzeichnet ist, und um bei Vorliegen des charakteristischen Verlaufs das zweite Neigungssignal (123) als korrigiertes Neigungssignal (132) auszugeben.

10. Arbeitsmaschine gemäß einem der vorhergehenden Ansprüche, wobei die Fusionsvorrichtung (130) ausgebildet ist, um den zeitlichen Verlauf des ersten und/oder des zweiten Neigungssignals (113, 123) hinsichtlich eines Drifts zu beobachten, um einen aus dem Drift resultierenden Offsetfehler und/oder Verstärkungsfehler zu kompensieren oder um das Sensorsignal ohne Drift als korrigiertes Neigungssignal (132) auszugeben.

11. Arbeitsmaschine gemäß einem der vorhergehenden Ansprüche, wobei das Sensorsystem einen oder mehrere Temperatursensoren zur Überwachung der Umgebungstemperatur des MEMS-Neigungssensors (110) und/oder des weiteren Neigungssensors (120) umfasst, wobei die Fusionsvorrichtung (130) ausgebildet ist, um das korrigierte Neigungssignal (132) unter Berücksichtigung von einem oder mehreren Temperaturwerten der einen oder mehreren Temperatursensoren zu bestimmen und/oder das erste, das zweite und/oder das korrigierte Neigungssignal (132) in Abhängigkeit von den einen oder mehreren Temperaturwerten zu korrigieren.

12. Arbeitsmaschine gemäß einem der vorhergehenden Ansprüche, wobei das Neigungssensorsystem (100) an einem Oberwagen (21, 43, 33), Ausleger (24, 44, 31), Teleskopausleger (24, 44) oder Arbeitsbühne (23) angeordnet ist.

13. Verfahren zur Neigungsmessung bei einer mobilen Arbeitsmaschine in Form einer Hubarbeitsbühne oder eines Krans, mit folgenden Schritten:
Ermitteln einer an dem Neigungssensor vorherrschenden Neigung mittels eines MEMS-Neigungssensors (110) und Ausgeben eines ersten Neigungssignals (113) in Abhängigkeit von der Neigung;
Ermitteln der an dem Neigungssensor vorherrschenden Neigung mittels eines weiteren Neigungssensors (120), wobei der weitere Neigungssensor (120) einen thermodynamischen Neigungssensor umfasst, und Ausgeben eines zweiten Neigungssignals (123) in Abhängigkeit von der an dem Neigungssensor vorherrschenden Neigung; und
Bestimmen oder Berechnen einer korrigierten Neigung basierten auf dem ersten (113) und zweiten (123) Neigungssignal, um ein korrigiertes Neigungssignal (132) auszugeben;
wobei zumindest der MEMS-Neigungssensor (110) und der weitere Neigungssensor (120) in einem gemeinsamen Gehäuse (125) des Neigungssensorsystems (100) angeordnet sind.

14. Computerprogramm mit einem Programmcode zur Durchführung des Verfahrens nach Anspruch 13, wenn das Programm auf einem Computer abläuft.

## Claims

1. A mobile work machine (10, 11, 12) having an inclination sensor system (100), comprising:
an MEMS inclination sensor (110) configured to output a first inclination signal (113) starting from an inclination present at the inclination sensor;
a further inclination sensor (120) of a different type, configured to output a second inclination signal (123) starting from the inclination present at the further inclination sensor, the further inclination sensor (120) comprising a thermodynamic inclination sensor; and
a fusion device (130) configured to determine or calculate a corrected inclination based on the first (113) and second inclination signals (123), and output the same as a corrected inclination signal (132);
wherein the work machine is a lifting platform or a crane, and wherein at least the MEMS inclination sensor (110) and the further inclination sensor (120) are arranged in a common housing (125) of the inclination sensor system (100).

2. The work machine in accordance with claim 1, wherein the MEMS inclination sensor (110) is manufactured based on surface MEMS technologies.

3. The work machine in accordance with claim 2, wherein the MEMS inclination sensor (110) comprises one or more layers grown onto a substrate, in which the MEMS structure is introduced, and/or wherein the MEMS inclination sensor (110) comprises a substrate on the surface of which the MEMS structures are formed.

4. The work machine in accordance with any of the preceding claims, wherein the fusion device (130) is configured to compare the first (113) and second inclination signals (123) and output, with no deviations, the first inclination signal (113) as the corrected inclination signal (132).

5. The work machine in accordance with any of the preceding claims, wherein the fusion device (130) is configured to compare the first (113) and second inclination signals (123) and output, in the case of deviations, the second inclination signal (123) as the corrected inclination signal (132).

6. The work machine in accordance with any of the preceding claims, wherein the fusion device (130) is configured to examine the first inclination signal (113) by means of an FFT and to output, when recognizing a deviation in the frequency spectrum or when exceeding a predetermined level of one or more frequency portions, the second inclination signal (123) as the corrected inclination signal (132).

7. The work machine in accordance with any of the preceding claims, wherein the fusion device (130) is configured to examine a timeline of the first inclination signal (113) as to discontinuities and to output, in the case of discontinuities, the second inclination signal (123) as the corrected inclination signal (132).

8. The work machine in accordance with any of the preceding claims, wherein the fusion device (130) is configured to detect, in a timeline of the first inclination signal (113), peak values **characterized by** a change in signal of at least .1%, .5%, 2%, 5% or 10% when compared to the previous level within a time period of less than 100 ms, 500 ms or less than 1 second, and to output, in the case of peak values, the second inclination signal (123) as the corrected inclination signal (132).

9. The work machine in accordance with any of the preceding claims, wherein the fusion device (130) is configured to examine the timeline of the first inclination signal (113) as to a characteristic waveform **characterized by** an increasing first inclination signal (113) with a subsequent plateau at a maximum value for the first sensor signal, and to output, in the case of the characteristic waveform, the second inclination signal (123) as the corrected inclination signal (132).

10. The work machine in accordance with any of the preceding claims, wherein the fusion device (130) is configured to observe the timeline of the first and/or second inclination signals (113, 123) as to a drift in order to compensate an offset error resulting from the drift and/or amplification error, or to output the sensor signal with no drift as the corrected inclination signal (132).

11. The work machine in accordance with any of the preceding claims, wherein the sensor system comprises one or more temperature sensors for monitoring the environmental temperature of the MEMS inclination sensor (110) and/or of the further inclination sensor (120), wherein the fusion device (130) is configured to determine the corrected inclination signal (132) while considering one or more temperature values of the one or more temperature sensors and/or to correct the first, second and/or corrected inclination signals (132) in dependence on the one or more temperature values.

12. The work machine in accordance with any of the preceding claims, wherein the inclination sensor system (100) is arranged at an upper carriage (21, 43, 33), cantilever (24, 44, 31), telescope cantilever (24, 44) or lifting platform (23).

13. A method for measuring an inclination in a mobile work machine implemented as a lifting platform or a crane, comprising the steps of:
establishing an inclination present at the inclination sensor by means of an MEMS inclination sensor (110) and outputting a first inclination signal (113) in dependence on the inclination;
establishing the inclination present at the inclination sensor by means of a further inclination sensor (120), the further inclination sensor (120) comprising a thermodynamic inclination sensor, and outputting a second inclination signal (123) in dependence on the inclination present at the inclination sensor; and
determining or calculating a corrected inclination based on the first (113) and second (123) inclination signals in order to output a corrected inclination signal (132);
wherein at least the MEMS inclination sensor (110) and the further inclination sensor (120) are arranged in a common housing (125) of the inclination sensor system (100).

14. A computer program comprising program code for performing the method in accordance with claim 13 when the program runs on a computer.

## Revendications

1. Machine de travail mobile (10, 11, 12) avec un système de capteur d'inclinaison (100), aux caractéristiques suivantes:
un capteur d'inclinaison MEMS (110) qui est conçu pour sortir, partant d'une l'inclinaison existante au capteur d'inclinaison, un premier signal d'inclinaison (113);
un autre capteur d'inclinaison (120) d'un autre type qui est conçu pour sortir, partant de l'inclinaison existante à l'autre capteur d'inclinaison, un deuxième signal d'inclinaison (123), où l'autre capteur d'inclinaison (120) comporte un capteur d'inclinaison thermodynamique; et
un dispositif de fusion (130) qui est conçu pour déterminer ou calculer une inclinaison corrigée sur base du premier (113) et du deuxième signal d'inclinaison (123) et pour la sortir comme signal d'inclinaison corrigé (132);
dans laquelle la machine de travail est une plate-forme de travail de levage ou une grue et dans laquelle au moins le capteur d'inclinaison MEMS (110) et l'autre capteur d'inclinaison (120) sont disposés dans un boîtier commun (125) du système de capteur d'inclinaison (100).

2. Machine de travail selon la revendication 1, dans laquelle le capteur d'inclinaison MEMS (110) est fabriqué sur base de technologies MEMS de surface.

3. Machine de travail selon la revendication 2, dans laquelle le capteur d'inclinaison MEMS (110) comporte une ou plusieurs couches cultivées sur un substrat dans lesquelles est introduite la structure MEMS, et/ou dans laquelle le capteur d'inclinaison MEMS (110) comporte un substrat sur la surface duquel sont formées les structures MEMS.

4. Machine de travail selon l'une des revendications précédentes, dans laquelle le dispositif de fusion (130) est conçu pour comparer le premier (113) et le deuxième signal d'inclinaison (123) et pour sortir sans différences le premier signal d'inclinaison (113) comme signal d'inclinaison corrigé (132).

5. Machine de travail selon l'une des revendications précédentes, dans laquelle le dispositif de fusion (130) est conçu pour comparer le premier (113) et le deuxième signal d'inclinaison (123) et pour sortir, en cas de différences, le deuxième signal d'inclinaison (123) comme signal d'inclinaison corrigé (132).

6. Machine de travail selon l'une des revendications précédentes, dans laquelle le dispositif de fusion (130) est conçu pour examiner le premier signal d'inclinaison (113) au moyen d'une FFT et pour sortir, en cas de détection d'une différence dans le spectre de fréquences ou de dépassement d'un niveau prédéterminé d'une ou de plusieurs parts de fréquence, le deuxième signal d'inclinaison (123) comme signal d'inclinaison corrigé (132).

7. Machine de travail selon l'une des revendications précédentes, dans laquelle le dispositif de fusion (130) est conçu pour examiner une évolution dans le temps du premier signal d'inclinaison (113) en ce qui concerne des discontinuités et à sortir, en cas de discontinuités, le deuxième signal d'inclinaison (123) comme signal d'inclinaison corrigé (132).

8. Machine de travail selon l'une des revendications précédentes, dans laquelle le dispositif de fusion (130) est conçu pour détecter, dans une évolution dans le temps du premier signal d'inclinaison (113), les crêtes de valeur qui sont **caractérisées par** une modification de signal d'au moins 0,1%, 0,5%, 2%, 5% ou 10% par rapport au niveau précédent au cours d'une période de moins de 100 ms, 500 ms ou de moins de 1 seconde, et pour sortir, en cas de présence de crêtes de valeur, le deuxième signal d'inclinaison (123) comme signal d'inclinaison corrigé (1.32).

9. Machine de travail selon l'une des revendications précédentes, dans laquelle le dispositif de fusion (130) est conçu pour rechercher l'évolution dans le temps du premier signal d'inclinaison (113) en ce qui concerne une évolution caractéristique qui est **caractérisée par** un premier signal progressif (113) avec une formation de plateau à une valeur maximale qui suit pour le premier signal de capteur, et pour sortir, en cas de présence de l'évolution caractéristique, le deuxième signal d'inclinaison (123) comme signal d'inclinaison corrigé (132).

10. Machine de travail selon l'une des revendications précédentes, dans laquelle le dispositif de fusion (130) est conçu pour observer l'évolution dans le temps du premier et/ou du deuxième signal d'inclinaison (113, 123) en ce qui concerne une dérive, pour compenser une erreur de décalage et/ou une erreur d'amplification résultant de la dérive, ou pour sortir le signal de capteur sans dérive comme signal d'inclinaison corrigé (132).

11. Machine de travail selon l'une des revendications précédentes, dans laquelle le système de capteur comporte un ou plusieurs capteurs de température destinés à surveiller la température ambiante du capteur d'inclinaison MEMS (110) et/ou de l'autre capteur d'inclinaison (120), dans laquelle le dispositif de fusion (130) est conçu pour déterminer le signal d'inclinaison corrigé (132) en tenant compte d'une ou plusieurs valeurs de température des un ou plusieurs capteurs de température, et/ou pour corriger le premier, le deuxième signal d'inclinaison et/ou le signal d'inclinaison corrigé (132) en fonction des une ou plusieurs valeurs de température.

12. Machine de travail selon l'une des revendications précédentes, dans laquelle le système de capteur d'inclinaison (100) est disposé sur une structure supérieure (21, 43, 33), une flèche (24, 44, 31), une flèche télescopique (24, 44) ou une plate-forme de travail (23).

13. Procédé de mesure d'inclinaison sur une machine de travail mobile sous forme d'une plate-forme de levage ou d'une grue, aux étapes suivantes consistant à:
déterminer une inclinaison existante au capteur d'inclinaison au moyen d'un capteur d'inclinaison MEMS (110) et sortir un premier signal d'inclinaison (113) en fonction de l'inclinaison;
déterminer l'inclinaison existante au capteur d'inclinaison au moyen d'un autre capteur d'inclinaison (120), où l'autre capteur d'inclinaison (120) comporte un capteur d'inclinaison thermodynamique, et sortir un deuxième signal d'inclinaison (123) en fonction de l'inclinaison existante au capteur d'inclinaison; et
déterminer ou calculer une inclinaison corrigée sur base du premier (113) et du deuxième (123) signal d'inclinaison, pour sortir un signal d'inclinaison corrigé (132);
dans lequel au moins le capteur d'inclinaison MEMS (110) et l'autre capteur d'inclinaison (120) sont disposés dans un boîtier commun (125) du système de capteur d'inclinaison (100).

14. Programme d'ordinateur avec un code de programme pour la mise en œuvre du procédé selon la revendication 13 lorsque le programme est exécuté sur un ordinateur.
